# EUROPEAN PATENT SPECIFICATION

(11) **EP 4 376 068 B1**
(45) Date of publication and mention of the grant of the patent: **16.07.2025**
(21) Application number: 23210337.4
(22) Date of filing: 16.11.2023
(51) Int. Cl.: H01L 23/13, H01L 23/538, H05K 1/18, H01L 23/367, H05K 1/02, H01L 23/15, H01L 23/48, H01L 23/373, H01L 23/498

(54) **PACKAGING SUBSTRATE AND SEMICONDUCTOR PACKAGE INCLUDING THE SAME**
VERPACKUNGSSUBSTRAT UND HALBLEITERGEHÄUSE DAMIT
SUBSTRAT D'ENCAPSULATION ET BOÎTIER DE SEMI-CONDUCTEUR LE COMPRENANT

(30) Priority: 22.11.2022 US 202263427436 P
(43) Date of publication of application: 29.05.2024
(73) Proprietor: Absolics Inc., Covington, GA 30014 (US)
(72) Inventor: KIM, Sungjin, Covington, GA 30014 (US)
(74) Representative: BCKIP Part mbB

(56) References cited:
- JP-A- 2012 164 956
- US-A1- 2012 168 206
- US-A1- 2022 051 972

## Description

The present application claims priority to Provisional Application No. 63/427,436 filed on November 22, 2022.

### BACKGROUND

### 1. Technical field

The present invention relates to a packaging substrate having excellent heat dissipation characteristics and durability, and a semiconductor package including the same.

### 2. Related Art

In manufacturing electronic components, implementing a circuit on a semiconductor wafer is referred to as a front-end (FE) process, assembling the wafer into a state that can be used in an actual product is referred to as a back-end (BE) process, and a packaging process is included in the BE process.

Four key technologies of the semiconductor industry that enable the rapid development of electronic products in recent years include semiconductor technology, semiconductor packaging technology, manufacturing process technology, and software technology. The semiconductor technology has been developed in various forms such as line widths of a nanometer unit, which is smaller than a micrometer unit, 10 million or more cells, high-speed operation, and high heat dissipation, but the technology of packaging them completely is not being supported yet. Thus, the electrical performance of semiconductors may be determined by the packaging technology and the resulting electrical connection rather than the performance of the semiconductor technology itself.

Ceramic or resin is applied as a material of a packaging substrate. In the case of a ceramic substrate, it is not easy to mount a high-performance and high-frequency semiconductor element thereon due to a high resistance value or high dielectric constant. In the case of a resin substrate, a relatively high-performance and high-frequency semiconductor element may be mounted thereon, but there is a limit in pitch reduction of wirings.

Recently, research is being conducted to apply silicon or glass as a high-end packaging substrate. By forming a through-hole in a silicon or glass substrate and applying a conductive material into the through-hole, a wiring length between an element and a motherboard may be shortened and excellent electrical characteristics may be obtained.

Document US 2022 / 0 051 972 A1 discloses a packaging substrate and semiconductor device. The semiconductor device includes an element unit comprising a semiconductor element and a packaging substrate electrically connected to the element unit. A glass substrate is applied as a core of the packaging substrate. The packaging substrate improves electrical properties such as a signal transmission rate by connecting the semiconductor element and a motherboard to be closer to each other so that electrical signals are transmitted through a short path. Similar substrates and semiconductor devices are disclosed in US 2012/168206 A1 and in JP 2012 164956 A.

### SUMMARY

### [Problem to solve]

The object of the present invention is to provide a packaging substrate having excellent heat dissipation characteristics and long-term durability, and a semiconductor package including the same.

### [Means for solving problems]

To this end, the present invention provides a packaging substrate in accordance with claim 1 and a semiconductor package in accordance with claim 10.

According to the present invention, a packaging substrate has an upper surface and a lower surface.

The packaging substrate includes a mounting region in which an element is accommodated and a core substrate in which the mounting region is disposed.

The core substrate is selected from a ceramic substrate, a glass substrate, or a combination thereof.

The mounting region includes a cavity portion formed by recessing a portion of the core substrate, a cavity portion side surface formed inside the core substrate in a thickness direction of the core substrate to form an outer periphery of the cavity portion, and a first heat dissipation portion disposed adjacent to the outer periphery of the cavity portion.

The first heat dissipation portion is a thermal path through which heat of the packaging substrate is transmitted to the outside.

The first heat dissipation portion includes one or more heat dissipation vias each having an area of 5,000 µm² to 75 mm² when viewed from the upper surface of the packaging substrate.

An aspect ratio of the heat dissipation via observed from the upper surface of the packaging substrate may be 0.1 to 10.

When observed from the upper surface of the packaging substrate, the heat dissipation via may be disposed to be spaced apart from the cavity portion by 50 µm to 1,000 µm.

The packaging substrate may include two or more heat dissipation vias.

The heat dissipation vias may be disposed at an interval of 50 µm to 1,000 µm.

When observed from the upper surface of the packaging substrate, a ratio of an area of the entire heat dissipation vias to an area of the cavity portion may be 1 to 50.

According to the invention, the heat dissipation via has a longitudinal diameter and a transverse diameter.

Further, the heat dissipation via has a structure in which at least one of the longitudinal diameter and the transverse diameter is changed in the thickness direction of the core substrate.

In the heat dissipation via, a minimum value between the longitudinal diameter and the transverse diameter is greater than or equal to 50 µm.

When the packaging substrate is observed from a cross section in a direction perpendicular to the upper surface of the packaging substrate, the heat dissipation via may have an hourglass shape.

The mounting region may include a second heat dissipation portion that is a part formed on an inner side of the cavity portion and disposed adjacent to the cavity portion side surface to transmit heat to the outside.

The mounting region may include a thermally conductive part configured to thermally connect the second heat dissipation portion and the heat dissipation via.

The heat dissipation via may include a thermally conductive layer.

A difference value in thermal expansion coefficients between the thermally conductive layer and the core substrate may be less than or equal to 10 ppm/°C.

A semiconductor package according to another embodiment of the present invention includes the packaging substrate and a main board electrically connected to the packaging substrate.

### [Effect of invention]

The packaging substrate of the present invention may represent excellent heat dissipation characteristics and long-term durability.

### BRIEF DESCRIPTION OF THE DRAWINGS

FIG. 1a is a plan view illustrating a packaging substrate according to one embodiment of the present invention.
FIG. 1b is a cross-sectional view taken along line A-A' of FIG. 1a.
FIG. 2a is a conceptual view illustrating a spacing distance between a heat dissipation via and a cavity portion.
FIG. 2b is an enlarged view of portion B of FIG. 2a.
FIG. 3a is a conceptual diagram illustrating a packaging substrate according to another embodiment of the present invention.
FIG. 3b is a conceptual diagram illustrating a packaging substrate according to still another embodiment of the present invention.
FIG. 4 is a conceptual diagram illustrating a packaging substrate according to yet another embodiment of the present invention.
FIG. 5a is a plan view illustrating a packaging substrate according to yet another embodiment of the present invention.
FIG. 5b is a cross-sectional view taken along line C-C' of FIG. 5a.
FIG. 6 is a conceptual diagram illustrating a packaging substrate according to yet another embodiment of the present invention.

### DESCRIPTION OF EXEMPLARY EMBODIMENTS

Hereinafter, embodiments will be described in detail with reference to the accompanying drawings so that a person skilled in the art to which the present invention pertains could easily implement. However, the present invention may be implemented in many different forms and is not limited to the embodiments described herein. Like reference numerals designate like components throughout the specification.

Throughout the present specification, the phrase "combination(s) thereof" included in a Markush-type expression refers to one or more mixtures or combinations selected from the group consisting of components stated in the Markush-type expression, that is, denotes that one or more components selected from the group consisting of the components are included.

Throughout the present specification, terms such as "first," "second," "A," or "B" are used to distinguish the same terms from each other. In addition, the singular forms include the plural form unless the context clearly dictates otherwise.

In the present specification, the term "~based" may mean that a compound includes a compound corresponding to "~", or a derivative of "~".

In the present specification, "B being disposed on A" means that B is disposed in direct contact with A or disposed over A with another layer interposed therebetween and thus should not be interpreted as being limited to B being disposed in direct contact with A.

In the present specification, "B being connected to A" means that B is connected to A directly or through another component therebetween, and thus should not be interpreted as being limited to B being directly connected to A, unless otherwise noted.

In the present specification, unless specially stated otherwise, a singular form is contextually interpreted as including a plural form as well as a singular form.

In the drawings of the present specification, the shape, relative size, angle, and the like of each component may be exaggerated for the purpose of illustration, and no rights shall be construed to be limited to the drawings.

In the present specification, "A being adjacent to B" means that A and B are located in contact with each other, or A and B are not in contact with each other but are located close to each other. In the present specification, unless specially stated otherwise, the expression that A and B are adjacent to each other shall not be construed as limiting that A and B are located in contact with each other.

In the present specification, unless otherwise stated, the term "fine line" refers to a line having a width of 5 µm or less, and illustratively refers to a line having a width of 1 to 4 µm.

In the present specification, a difference value between A value and B value refers to an absolute value of a value obtained by subtracting B value from A value.

Heat may be generated in a process of operating an element mounted on a packaging substrate. The heat generation may cause performance degradation of the element, bending of the substrate, and the like. In particular, as active elements are frequently mounted on a packaging substrate, the demand for a packaging substrate having more effective heat dissipation characteristics is increased.

Meanwhile, for thermal control, conventionally, a heat dissipation part made of a metal material having excellent thermal conductivity is applied to a packaging substrate made of an organic material. However, when such a method is simply applied to a substrate to which a ceramic material or the like is applied, durability degradation such as defects in the substrate and/or the heat dissipation part may occur during a manufacturing process.

The inventors of the present invention have confirmed that, by applying a first heat dissipation portion disposed adjacent to a cavity portion and adjusting an area of a heat dissipation via disposed in the first heat dissipation portion, it is possible to provide a packaging substrate having excellent heat dissipation characteristics and long-term durability, and have completed the present invention.

Hereinafter, the present invention will be described in detail.

### Core substrate

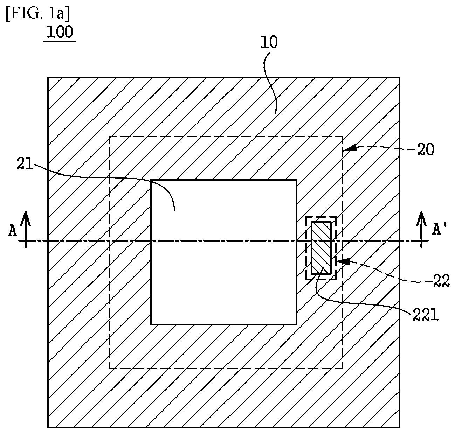

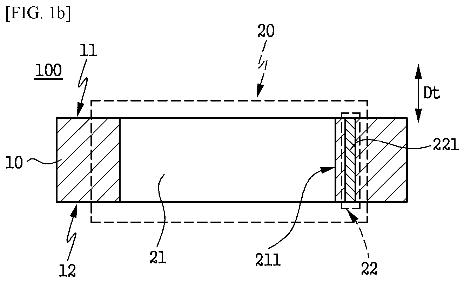

FIG. 1a is a plan view illustrating a packaging substrate according to one embodiment of the present invention. FIG. 1b is a cross-sectional view taken along line A-A' of FIG. 1a. The packaging substrate of the present invention will be described with reference to FIGS. 1a and 1b.

A packaging substrate 100 according to the present invention has an upper surface 11 and a lower surface 12.

The packaging substrate 100 includes a mounting region 20 in which an element is accommodated and a core substrate 10 in which the mounting region 20 is disposed.

The core substrate 10 serves as a support in the packaging substrate 100. The core substrate 10 is distinguished from a redistribution layer (not shown) or a bump (not shown) disposed above or under the core substrate 10.

As the core substrate 10, a substrate selected from a ceramic substrate, a glass substrate, or a combination thereof is applied.

As the ceramic substrate, for example, a silicon-based ceramic substrate, a glass-based ceramic substrate, or the like may be applied. The silicon-based ceramic substrate may be a substrate including some or all of a silicon substrate, a silicon carbide substrate, and the like. The glass-based ceramic substrate may be a substrate including some or all of a quartz substrate, a sapphire substrate, and the like.

As the glass substrate, for example, an alkali-borosilicate plate glass, an alkali-free borosilicate plate glass, an alkali-free alkaline earth borosilicate plate glass, or the like may be applied, as long as it is a plate glass applied as an electronic component. As the glass substrate, a glass substrate for an electronic device may be applied, and a glass substrate manufactured by, for example, SCHOTT, AGC, Coming, or the like may be applied, but the present invention is not limited thereto.

A thickness of the core substrate 10 may be greater than or equal to 50 µm.The thickness may be greater than or equal to 100 µm. The thickness may be greater than or equal to 250 µm. The thickness may be greater than or equal to 400 µm. The thickness may be greater than or equal to 500 µm. The thickness may be less than or equal to 3000 µm. The thickness may be less than or equal to 2000 µm. The thickness may be less than or equal to 1000 µm. In this case, the thickness refers to a thickness of the core substrate in a portion excluding a cavity region. When the core substrate 10 having such a thickness is applied, the core substrate 10 may have excellent utilization as a substrate for semiconductor packaging.

The mounting region 20 includes a cavity portion 21 which is a space formed by recessing a portion of the core substrate 10, and a cavity portion side surface 211 which is formed inside the core substrate in a thickness direction Dt of the core substrate and forms an outer periphery of the cavity portion 21.

The cavity portion 21 may be formed by vertically passing through the core substrate 10 (see FIG. 1b). However, the present invention is not limited thereto, and the cavity portion 21 may be formed by partially recessing an upper or lower surface of the core substrate 10 rather than vertically passing through the core substrate 10.

The cavity portion side surface 211 may be formed perpendicular to the upper or lower surface of the core substrate 10, but the present invention is not limited thereto. When observing the core substrate 10 from a cross section, the side surface 13 of the cavity region may form an inclined surface or a curved surface.

The core substrate 10 having the cavity portion 21 may be manufactured by removing a portion of an upper portion corresponding to the cavity portion 21 of the core substrate 10. The core substrate 10 may be manufactured by stacking or combining substrates having different thicknesses.

Specifically, the cavity portion 21 may be formed by etching a portion of the upper portion corresponding to the cavity portion 21 of the core substrate 10 or applying mechanical force to remove the portion of the upper portion. However, the present invention is not limited thereto.

An element may be placed in the cavity portion 21. A description of the element is overlapped to a description to be provided below, and thus will be omitted.

### First heat dissipation portion

The mounting region 20 further includes a first heat dissipation portion 22 disposed adjacent to the outer periphery of the cavity portion 21.

The first heat dissipation portion 22 is a thermal path through which heat of the packaging substrate 100 is transmitted to the outside.

One heat dissipation via 221 may be disposed in the first heat dissipation portion 22. The heat dissipation via 221 may have the structure of a hole formed by recessing a portion of the core substrate 10, and may have a structure including a thermally conductive layer disposed in the hole.

Specifically, the heat dissipation via 221 may be formed in the thickness direction Dt of the core substrate. The heat dissipation via 221 may be formed by vertically passing through the core substrate 10 (see FIG. 1b). However, the heat dissipation via 221 is not limited thereto. That is, the heat dissipation via 221 may have a structure in which an upper side or a lower side of the heat dissipation via 221 is blocked (not shown) rather than vertically passing through the core substrate 10.

At least a portion of the heat dissipation via 221 may be connected to a ground body (not shown). Specifically, at least a portion of the heat dissipation via 221 may be electrically connected to the ground body.

The first heat dissipation portion 22 includes at least one heat dissipation via 221 having an area of 5000 *µ*m² to 75 mm² when observed from the upper surface 11 of the packaging substrate.

According to the present invention, by controlling the area of the heat dissipation via 221 observed from the upper surface 11 of the substrate, heat generated from the element may be more effectively emitted to the outside of the packaging substrate 100. At the same time, when a thermally conductive layer is formed in the heat dissipation via 221, plating defects or filling defects may be suppressed, and thus the first heat dissipation portion 22 may have stable reliability.

The first heat dissipation portion 22 may include at least one heat dissipation via 221 having an area of 5,000 *µ*m² or more when observed from the upper surface 11 of the packaging substrate. The area of the heat dissipation via observed from the upper surface 11 of the packaging substrate may be greater than or equal to 10,000 µm². The area of the heat dissipation via may be greater than or equal to 50,000 µm². The area of the heat dissipation via may be greater than or equal to 1 mm². The area of the heat dissipation via may be greater than or equal to 5 mm². The area of the heat dissipation via may be greater than or equal to 10 mm². The area of the heat dissipation via may be greater than or equal to 20 mm². The area of the heat dissipation via may be greater than or equal to 25 mm². The area of the heat dissipation via may be less than or equal to 75 mm². The area of the heat dissipation via may be less than or equal to 70 mm². The area of the heat dissipation via may be less than or equal to 65 mm². The area of the heat dissipation via may be less than or equal to 60 mm². In this case, the thermal emission amount and long-term reliability of the first heat dissipation portion 22 may be simultaneously improved.

The first heat dissipation portion 22 may include at least one heat dissipation via 221 having an area of 5,000 µm² or more when observed from the lower surface 12 of the packaging substrate. An area of the heat dissipation via observed from the lower surface 12 of the packaging substrate may be greater than or equal to 10,000 µm². The area of the heat dissipation via may be greater than or equal to 50,000 µm². The area of the heat dissipation via may be greater than or equal to 1 mm². The area of the heat dissipation via may be greater than or equal to 5 mm². The area of the heat dissipation via may be greater than or equal to 10 mm². The area of the heat dissipation via may be greater than or equal to 20 mm². The area of the heat dissipation via may be greater than or equal to 25 mm². The area of the heat dissipation via may be less than or equal to 75 mm². The area of the heat dissipation via may be less than or equal to 70 mm². The area of the heat dissipation via may be less than or equal to 65 mm². The area of the heat dissipation via may be less than or equal to 60 mm². In this case, it is possible to efficiently transmit heat to the outside of the substrate through the lower surface 12 of the packaging substrate, which may contribute to improving the heat dissipation characteristics of the packaging substrate 100. In addition, a thermally conductive layer having a packing density of the level desired in the present invention may be formed in an entire region of the heat dissipation via 221.

An aspect ratio of the heat dissipation via 221 observed from the upper surface 11 of the packaging substrate may be 0.1 to 10.

According to the present invention, the aspect ratio of the heat dissipation via 221 may be controlled within a range preset in the present invention. The heat dissipation via 221 having such a structure may efficiently receive heat generated from the element over a wider area. In addition, when a thermally conductive layer is formed inside the heat dissipation via 221 having such a shape, a thermally conductive filler or metal may be smoothly filled in the hole of the heat dissipation via 221.

The aspect ratio of the heat dissipation via 221 observed from the upper surface 11 of the packaging substrate may be greater than or equal to 0.1. The aspect ratio may be greater than or equal to 0.5. The aspect ratio may be greater than or equal to 1. The aspect ratio may be greater than or equal to 2. The aspect ratio may be greater than or equal to 3. The aspect ratio may be less than or equal to 10. The aspect ratio may be less than or equal to 8. In this case, it may help the heat dissipation via 221 to effectively transmit more heat to the outside, and process convenience may be improved when forming the heat dissipation via 221.

An aspect ratio of the heat dissipation via 221 observed from the lower surface 12 of the packaging substrate may be greater than or equal to 0.1. The aspect ratio may be greater than or equal to 0.5. The aspect ratio may be greater than or equal to 1. The aspect ratio may be greater than or equal to 2. The aspect ratio may be greater than or equal to 3. The aspect ratio may be less than or equal to 10. The aspect ratio may be less than or equal to 8. In this case, the heat dissipation via may efficiently receive heat even at a lower portion of the packaging substrate, and the heat dissipation via 221 may be more easily formed.

When the packaging substrate is observed from a cross section in a direction perpendicular to the upper surface of the packaging substrate, the heat dissipation via may have a substantially uniform width. The fact that the heat dissipation via has a substantially uniform width means that a value obtained by subtracting a minimum value of the width from a maximum value of the width of the heat dissipation via is within 20% of the maximum value.

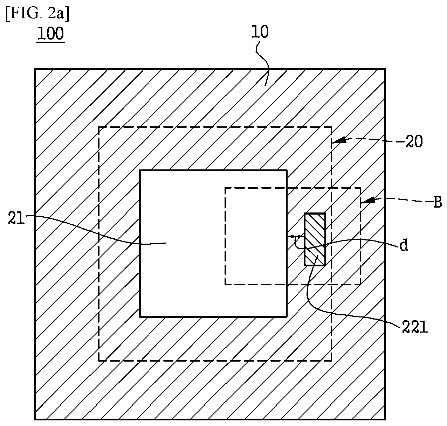

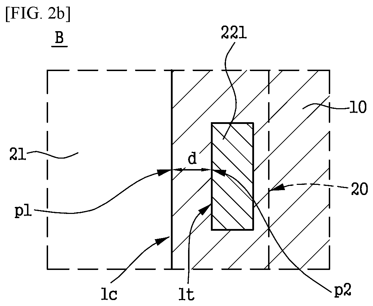

FIG. 2a is a conceptual diagram illustrating a spacing distance between the heat dissipation via and the cavity portion, and FIG. 2b is an enlarged view of portion B of FIG. 2a. Hereinafter, the packaging substrate of the present invention will be described with reference to FIGS. 2a and 2b.

When viewed from the upper surface 11 of the packaging substrate, the heat dissipation via 221 may be disposed to be spaced apart from the cavity portion 21 by 50 µm to 1000 µm.

According to the present invention, a spacing distance d between the heat dissipation via 221 and the cavity portion 21 may be adjusted. The heat dissipation via 221 may effectively suppress overheating of the core substrate during an element operating process. At the same time, in a process of forming the heat dissipation via 221 in the core substrate 10, it is possible to suppress the occurrence of cracks in the core substrate 10, specifically, a portion between the cavity portion 21 and the heat dissipation via 221 in the core substrate 10.

A method of measuring the spacing distance d between the heat dissipation via 221 and the cavity portion 21 is as follows. When observing from the upper surface 11 of the packaging substrate, a point located at an outline lc of the cavity portion 21 is referred to as a first point p1, and another point located at an outline lt of the heat dissipation via is referred to as a second point p2. A minimum distance between the first point p1 and the second point p2 is referred to as the spacing distance d between the heat dissipation via 221 and the cavity portion 21.

When viewed from the upper surface 11 of the packaging substrate, the heat dissipation via 221 may be disposed to be spaced apart from the cavity portion 21 by 1000 µm or less. The heat dissipation via 221 may be disposed to be spaced apart from the cavity portion 21 by 900 µm or less. The heat dissipation via 221 may be disposed to be spaced apart from the cavity portion 21 by 800 µm or less. The heat dissipation via 221 may be disposed to be spaced apart from the cavity portion 21 by 700 µm or less. The heat dissipation via 221 may be disposed to be spaced apart from the cavity portion 21 by 600 µm or less. The heat dissipation via 221 may be disposed to be spaced apart from the cavity portion 21 by 50 µm or more. The packaging substrate 100 may be suitable for mounting an active element with a relatively high heat generation, and may exhibit excellent durability.

When viewed from the lower surface 12 of the packaging substrate, the heat dissipation via 221 may be disposed to be spaced apart from the cavity portion 21 by 1000 µm or less. The heat dissipation via 221 may be disposed to be spaced apart from the cavity portion 21 by 900 µm or less. The heat dissipation via 221 may be disposed to be spaced apart from the cavity portion 21 by 800 µm or less. The heat dissipation via 221 may be disposed to be spaced apart from the cavity portion 21 by 700 µm or less. The heat dissipation via 221 may be disposed to be spaced apart from the cavity portion 21 by 600 µm or less. The heat dissipation via 221 may be disposed to be spaced apart from the cavity portion 21 by 50 µm or more. In the case of the packaging substrate 100, it is possible to more smoothly discharge heat upward and downward in the substrate while suppressing the generation of cracks in the substrate.

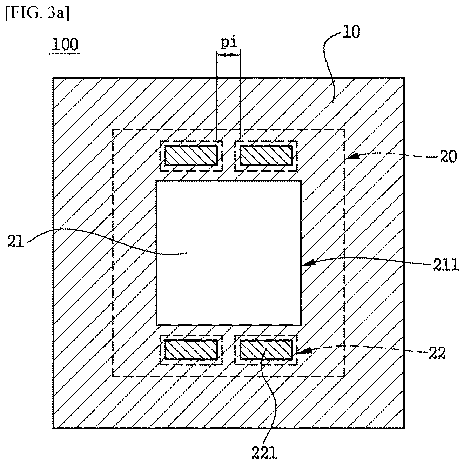

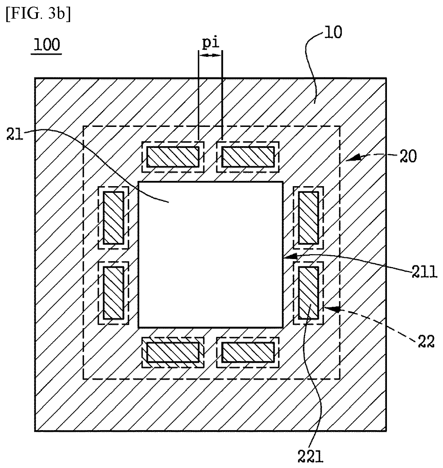

FIG. 3a is a conceptual diagram illustrating a packaging substrate according to another embodiment of the present invention. FIG. 3b is a conceptual diagram illustrating a packaging substrate according to still another embodiment of the present invention. Hereinafter, the present invention will be described with reference to FIGS. 3a and 3b.

A packaging substrate 100 has an upper surface and a lower surface, and includes a mounting region 20 in which an element is accommodated and a core substrate 10 in which the mounting region 20 is disposed. The specific configurations described in FIGS. 1a and 1b above are applied to the packaging substrate 100 as they are. Hereinafter, differences will be mainly described.

The packaging substrate 100 may include two or more heat dissipation vias 221. A plurality of heat dissipation vias 221 may be disposed to surround one side surface 211 of the cavity portion and another side surface 211 disposed to face the side surface 211 (see FIG. 3a). The plurality of heat dissipation vias 221 may be disposed to surround four side surfaces 211 of the cavity portion (see FIG. 3b).

The heat dissipation vias 221 may be disposed at an interval pi of 50 µm to 1000 µm.

In the packaging substrate 100 in which the interval between the heat dissipation vias 221 is controlled within a range preset in the present invention, the number of heat dissipation vias 221 sufficient to reliably discharge heat generated during an element operating process may be disposed, and the occurrence of cracks in a space between one heat dissipation via and another heat dissipation via while processing the core substrate 10 may be suppressed.

The interval between the heat dissipation vias 221 means a spacing distance between one heat dissipation via and another heat dissipation via disposed closest to the one heat dissipation via.

The heat dissipation vias 221 may be disposed at the interval pi of 50 µm to 1000 µm. The heat dissipation vias may be disposed at the interval pi of 70 µm or more. The heat dissipation vias may be disposed at the interval pi of 100 µm or more. The heat dissipation vias may be disposed at the interval pi of 150 µm or more. The heat dissipation vias may be disposed at the interval pi of 200 µm or more. The heat dissipation vias may be disposed at the interval pi of 900 µm or less. The heat dissipation vias may be disposed at the interval pi of 800 µm or less. The heat dissipation vias may be disposed at the interval pi of 700 µm or less. The heat dissipation vias may be disposed at the interval pi of 600 µm or less. In this case, the packaging substrate 100 with excellent heat dissipation characteristics and suppressed defect generation may be provided.

In the present invention, when observed from the upper surface of the packaging substrate, a ratio of an area of the entire heat dissipation vias to an area of the cavity portion may be adjusted. In the case of the packaging substrate in which the ratio is adjusted, the amount of heat that can be transmitted to the outside by the plurality of heat dissipation vias may be controlled according to an element area. Specifically, even when an active element having a relatively large area is mounted and operated in the substrate, and generates a relatively large amount of heat, this heat can be smoothly dissipated to the outside of the packaging substrate.

When observed from the upper surface of the packaging substrate, the ratio of the area of the entire heat dissipation vias to the area of the cavity portion may be 1 to 50. The ratio may be greater than or equal to 2. The ratio may be greater than or equal to 5. The ratio may be greater than or equal to 8. The ratio may be greater than or equal to 10. The ratio may be greater than or equal to 15. The ratio may be greater than or equal to 20. The ratio may be less than or equal to 45. The ratio may be less than or equal to 40. The ratio may be less than or equal to 35. The ratio may be less than or equal to 30. In this case, overheating of the packaging substrate can be effectively suppressed even when an element having a relatively high heat generation due to operating is mounted in the packaging substrate.

The heat dissipation via 221 may be formed in a manner that removes a predetermined region of the core substrate 10. The heat dissipation via 221 may be formed by etching the core substrate 10 by a physical and/or chemical method.

Specifically, a method of forming defects on a surface of the core substrate 10 with a laser or the like and then chemically etching, laser etching, or the like may be applied to the formation of the heat dissipation vias 221. However, the present invention is not limited thereto.

The area of the heat dissipation via 221, the aspect ratio, the spacing distance d between the heat dissipation via 221 and the cavity portion 21, the value of the interval pi between the heat dissipation vias, and the area of the cavity portion observed from the upper surface 11 of the packaging substrate, may be measured using a three-dimensional coordinate measuring machine (CMM).

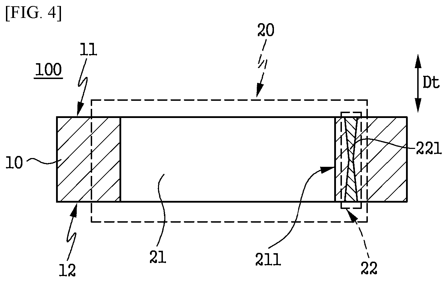

FIG. 4 is a conceptual diagram illustrating a packaging substrate according to yet another embodiment of the present invention. Hereinafter, the present invention will be described with reference to FIG. 4.

A packaging substrate 100 has an upper surface and a lower surface, and includes a mounting region 20 in which an element is accommodated and a core substrate 10 in which the mounting region 20 is disposed. The specific configurations described in FIGS. 1a and 1b above are applied to the packaging substrate 100 as they are. Hereinafter, differences will be mainly described.

A heat dissipation via 221 has a longitudinal diameter and a transverse diameter.

In the present invention, the heat dissipation via 221 has a structure in which at least one of the longitudinal diameter and the transverse diameter varies in a thickness direction Dt of the core substrate, and at the same time, a minimum value of the longitudinal and transverse diameters of the heat dissipation vias 221 is adjustable. In this case, a thermally conductive layer included in the heat dissipation via 221 may be firmly attached to the core substrate 10 even when sufficient adhesion with the core substrate 10 is not formed. In addition, a volume of the heat dissipation via 221 may be appropriately adjusted so that the heat dissipation via 221 can transmit a larger amount of heat to the outside of the substrate.

Specifically, when the packaging substrate 100 is observed from a cross section in a direction perpendicular to an upper surface 11 of the packaging substrate, the heat dissipation via 221 may have an hourglass shape. That is, the heat dissipation via 221 may have a shape in which a central portion is concave relative to upper and lower portions.

The heat dissipation via 221 may be formed in a manner that removes a predetermined region of each of an upper surface and a lower surface of the core substrate 10. As an example, a region located on the upper surface of the core substrate 10 may be irradiated with a laser to form a defect. Thereafter, the core substrate 10 may be chemically etched to a predetermined depth in the thickness direction Dt to form an inner space having a tapered shape in cross section. The inner space may have a structure that does not pass through the core substrate 10.

Subsequently, a region of the lower surface located opposite to the etched region of the upper surface may be etched in the same manner to form a hole for the heat dissipation via 221. The thermally conductive layer may be formed in the completed hole. However, the method of forming the heat dissipation via 221 is not limited thereto.

The shape of a cross section of the heat dissipation via 221, and the longitudinal/transverse diameters of the heat dissipation via 221 may be measured by scanning electron microscope (SEM). Specifically, the packaging substrate may be split so that the cross section of the heat dissipation via can be observed, and then the cross section of the split packaging substrate may be measured by SEM.

A minimum value between the longitudinal and transverse diameters of the heat dissipation via 221 is greater than or equal to 50 µm. The minimum value may be greater than or equal to 100 µm. The minimum value may be greater than or equal to 200 µm. The minimum value may be greater than or equal to 300 µm. The minimum value may be greater than or equal to 500 µm. The minimum value may be greater than or equal to 700 µm. The minimum value may be less than or equal to 1000 µm. In this case, it may contribute to further improving the long-term durability of the packaging substrate 100 with excellent heat dissipation characteristics.

The heat dissipation via 221 may include a thermally conductive layer (not shown). The thermally conductive layer may be formed by filling at least a portion of a hole space of the heat dissipation via 221 with a binder resin including a filler or plating the hole space.

A metal material may be applied to the thermally conductive layer. For example, at least one of copper, nickel, aluminum, gold, and silver may be applied to the metal material. However, any metal having thermal conductivity may be applied to the thermally conductive layer without being limited thereto.

A binder resin including a filler may be applied to the thermally conductive layer. A material having high thermal conductivity may be applied as the filler. As an example, an epoxy resin may be applied as the binder resin, and a metal filler and a carbonaceous filler may be applied as the filler, but the present invention is not limited thereto.

A thermal conductivity of the thermally conductive layer to which the metal material is applied may be 100 W/mK to 1000 W/mK. The thermal conductivity may be greater than or equal to 200 W/mK. The thermal conductivity may be greater than or equal to 300 W/mK. The thermal conductivity may be less than or equal to 800 W/mK.

A thermal conductivity of the thermally conductive layer to which the binder resin including a filler is applied may be 1 W/mK to 30 W/mK. The thermal conductivity may be greater than or equal to 3 W/mK. The thermal conductivity may be greater than or equal to 50 W/mK. The thermal conductivity may be less than or equal to 20 W/mK. The thermal conductivity may be less than or equal to 10 W/mK.

In this case, it may help the first heat dissipation portion 22 to transmit heat quickly.

The thermal conductivity of the thermally conductive layer may be measured by a laser flash method.

According to the present invention, long-term reliability of the packaging substrate 100 may be improved by controlling a difference value in thermal expansion coefficients between the thermally conductive layer and the core substrate 10. Specifically, in the case of the packaging substrate 100 in which the difference value is controlled, internal stress of the substrate, which may be formed due to a mismatch in thermal expansions of the core substrate 10 and the thermally conductive layer during an element operating process, may be effectively reduced. Accordingly, fatigue failure of the core substrate 10 due to long-term use may be suppressed.

The difference value in thermal expansion coefficients between the thermally conductive layer and the of the core substrate 10 may be less than or equal to 10 ppm/°C. The difference value may be less than or equal to 8 ppm/°C. The difference value may be greater than or equal to 0.5 ppm/°C. In this case, the durability of the packaging substrate 100 may be stably maintained for a long time.

A thermal expansion coefficient value of the core substrate 10 may be 5 ppm/°C to 20 ppm/°C. The thermal expansion coefficient value may be less than or equal to 15 ppm/°C. The thermal expansion coefficient value may be less than or equal to 12 ppm/°C. The thermal expansion coefficient value may be less than or equal to 10 ppm/°C.

A thermal expansion coefficient value of the thermally conductive layer may be greater than or equal to 4 ppm/°C. The thermal expansion coefficient may be greater than or equal to 8 ppm/°C. The thermal expansion coefficient may be greater than or equal to 12 ppm/°C. The thermal expansion coefficient may be less than or equal to 30 ppm/°C.

In this case, the core substrate 10 is prevented from being excessively expanded during the element operating process, and reliability degradation of the first heat dissipation portion 22 and the core substrate 10 due to the mismatch in thermal expansion characteristics between the core substrate 10 and the thermally conductive layer may be effectively suppressed.

The thermal expansion coefficients of the thermally conductive layer and the core substrate 10 may be measured by a thermal mechanical analyzer (TMA) using a thermomechanical analysis method. As an example, the thermal expansion coefficient may be measured using model Q400 TMA produced by TA Instruments, Inc.

### Second heat dissipation portion

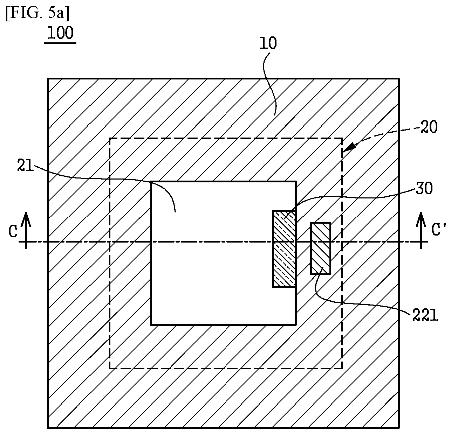

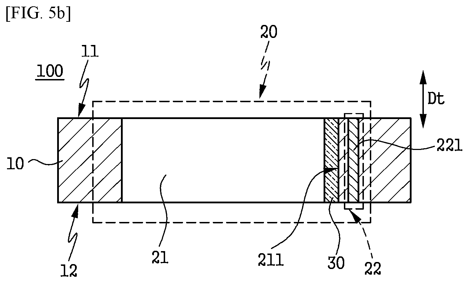

FIG. 5a is a plan view illustrating a packaging substrate according to yet another embodiment of the present invention, and FIG. 5b is a cross-sectional view taken along line C-C' of FIG. 5a. The present invention will be described with reference to FIGS. 5a and 5b.

A packaging substrate 100 has an upper surface and a lower surface, and includes a mounting region 20 in which an element is accommodated and a core substrate 10 in which the mounting region 20 is disposed. The specific configurations described in FIGS. 1a and 1b above are applied to the packaging substrate 100 as they are. Hereinafter, differences will be mainly described.

The mounting region 20 may include a second heat dissipation portion 30 formed on an inner side of a cavity portion 21 and disposed adjacent to a cavity portion side surface 211.

When an element is operated, the second heat dissipation portion 30 may help dissipate heat generated in the cavity portion 21 to the outside of the cavity portion 21, so that overheating of the packaging substrate 100 may be effectively suppressed.

As the second heat dissipation portion 30, a separate heat dissipation material may be applied, and a metal layer having heat dissipation characteristics may be applied. When a metal layer is applied as the second heat dissipation portion 30, the metal layer may be grounded to the outside and may be disposed in a form embedded in a separate material having insulating properties.

A metal material may be applied to the second heat dissipation portion 30. For example, at least one of copper, nickel, aluminum, gold, and silver may be applied to the metal material. However, any metal having thermal conductivity may be applied to the second heat dissipation portion 30 without being limited thereto.

A binder resin including a filler may be applied to the second heat dissipation portion 30. A material having high thermal conductivity may be applied as the filler. As an example, an epoxy resin may be applied as the binder resin, and a metal filler and a carbonaceous filler may be applied as the filler, but the present invention is not limited thereto.

A thermal expansion coefficient value of the second heat dissipation portion 30 may be greater than or equal to 4 ppm/°C. The thermal expansion coefficient may be greater than or equal to 8 ppm/°C. The thermal expansion coefficient may be greater than or equal to 12 ppm/°C. The thermal expansion coefficient may be less than or equal to 30 ppm/°C.

The second heat dissipation portion 30 may be disposed in contact with the cavity portion side surface 211. However, the present invention is not limited thereto, and the second heat dissipation portion 30 may be disposed adjacent to the cavity portion side surface 211 while not being in contact with the cavity portion side surface 211.

The same material as the material of the thermally conductive layer may be applied to the second heat dissipation portion 30. A material different from the material of the thermally conductive layer may be applied to the second heat dissipation portion 30.

The mounting region 20 may include a thermally conductive part thermally connecting the second heat dissipation portion 30 and the heat dissipation via 221. The thermally conductive part transmits heat received from the second heat dissipation portion 30 to the heat dissipation via 221 to help in rapid heat dissipation of the packaging substrate 100.

The thermally conductive part may have the form of a wiring. However, the form of the thermally conductive part is not limited as long as it has a structure capable of transmitting heat transmitted from the second heat dissipation portion 30 to the heat dissipation via 221.

The same material as the thermally conductive layer may be applied to the thermally conductive part. A description of the material of the thermally conductive part is overlapped to the above description, and thus will be omitted.

When a metal material is applied to the thermally conductive part, the thermally conductive part may have a structure electrically connected to a ground body.

### Each of other components in packaging substrate

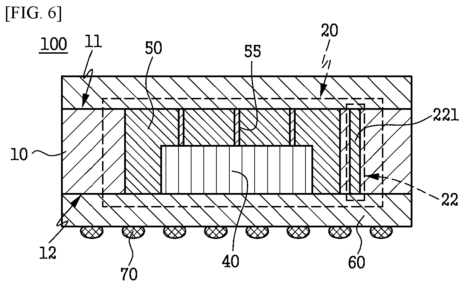

FIG. 6 is a conceptual diagram illustrating a packaging substrate according to yet another embodiment of the present invention. Hereinafter, the present invention will be described with reference to FIG. 6.

A packaging substrate 100 includes a mounting region 20 in which an element is accommodated and a core substrate 10 in which the mounting region 20 is disposed. The specific configurations described in FIGS. 1a and 1b above are applied to the packaging substrate 100 as they are. Hereinafter, differences will be mainly described.

The packaging substrate 100 may include an element 40 disposed in a cavity portion 21. As the element 40, not only a semiconductor element such as a central processing unit (CPU), a graphics processing unit (GPU), a memory chip, or the like, but also a capacitor element, a transistor element, an impedance element, other modules, or the like may be applied. That is, any semiconductor element mounted on a semiconductor device may be applied as the element 40 without limitation.

The packaging substrate 100 may have a structure in which the element 40 is embedded by an insulating layer 50. The insulating layer 50 may have a structure surrounding an upper surface and a side surface of the element 40.

The insulating layer 50 disposed on the upper surface of the element 40 may include an electrically conductive layer 55. The electrically conductive layer 55 may have a function of electrically connecting the element 40 to a redistribution layer 60 disposed on the core substrate 10.

The insulating layer 50 may be formed by a following method. The element 40 may be placed in a cavity portion 21. When the element 40 is placed in the cavity portion 21, an adhesive film may be adhered to a lower surface of the element 40 to fix the element 40. Thereafter, a resin film for an insulating layer is stacked on the cavity portion 21 in which the element 40 is placed, and is heated and pressed to form the insulating layer 50 on the element 40.

The packaging substrate 100 may include the redistribution layer 60 disposed on the core substrate 10. The redistribution layer 60 may include an insulating layer (not shown) and an electrically conductive layer (not shown) disposed in the insulating layer.

In the redistribution layer 60, the insulating layer and the electrically conductive layer may be disposed together. The redistribution layer 60 may be formed in a form in which the electrically conductive layer having a predetermined position and shape is embedded in the insulating layer. The electrically conductive layer may be formed with fine lines on at least a portion of the redistribution layer 60. The redistribution layer 60 may be electrically connected to the element 40.

The redistribution layer 60 may be formed in a process of repeatedly forming and removing the insulating layer and the electrically conductive layer.

The insulating layer may be formed of a build-up layer material such as an Ajinomoto Build-up Film (ABF) of Ajinomoto Co., Ltd, an undercoat material, or the like, but the present invention is not limited thereto.

The electrically conductive layer may include an electrically conductive material. As an example, the electrically conductive layer may include at least one of copper, nickel, aluminum, gold, or silver.

The packaging substrate 100 may further include the redistribution layer 60 and/or a bump 70 disposed under the core substrate 10.

A description of the redistribution layer 60 disposed under the core substrate 10 is overlapped to the above description, and thus will be omitted.

The redistribution layer 60 disposed on the core substrate 10 and the redistribution layer 60 disposed under the core substrate 10 may be electrically connected to each other by an electrically conductive layer (not shown) passing through the core substrate 10 according to a predetermined layout.

The bump 70 may be disposed under the core substrate 10. As an example, the bump 70 may be disposed under the packaging substrate 100 so as to be in contact with a main board or the like.

### Semiconductor package

A semiconductor package according to another embodiment of the present invention includes a packaging substrate 100 and a main board (not shown) electrically connected to the packaging substrate 100.

The packaging substrate 100 may be mounted on the main board and electrically connected to the main board.

The main board is not limited as long as it is commonly applied in the field of semiconductor devices.

A description of the packaging substrate 100 is redundant to the above description, and thus will be omitted.

While preferable embodiments of the present invention have been described in detail above, the right scope of the present invention is not limited thereto, but the present invention defined by the appended claims.

### [Description of reference number]

100: packaging substrate
10: core substrate
11: upper surface of packaging substrate 12: lower surface of packaging substrate
20: mounting region
21: cavity portion 211: cavity portion side surface
22: first heat dissipation portion 221: heat dissipation via
30: second heat dissipation portion
40: element
50: insulating layer
55: electrically conductive layer
60: redistribution layer
70: bump
d: spacing distance between the heat dissipation via and cavity portion
p1: first point p2: second point
lc: outline of cavity portion lt: outline of heat dissipation via
pi: interval between the heat dissipation vias
Dt: thickness direction of core substrate

## Claims

1. A packaging substrate (100) having an upper surface (11) and a lower surface (12), the packaging substrate (100) comprising:
a mounting region (20) in which an element is accommodated; and
a core substrate (10) in which the mounting region (20) is disposed,
wherein the core substrate (10) is selected from a ceramic substrate, a glass substrate, or a combination thereof, and
wherein the mounting region (20) comprises:
a cavity portion (21) formed by recessing a portion of the core substrate (10);
a cavity portion side surface (211) formed inside the core substrate (10) in a thickness direction of the core substrate (10) to form an outer periphery of the cavity portion (21); and
a first heat dissipation portion (22) disposed adjacent to the outer periphery of the cavity portion (21),
wherein the first heat dissipation portion (22) is a thermal path through which heat of the packaging substrate (100) is transmitted to the outside,
wherein the first heat dissipation portion (22) comprises one or more heat dissipation vias (221) each having an area of 5,000 µm² to 75 mm² when viewed from the upper surface (11) of the packaging substrate (100),
wherein the heat dissipation via (221) has a longitudinal diameter and a transverse diameter,
wherein the heat dissipation via (221) has a structure in which at least one of the longitudinal diameter and the transverse diameter is changed in the thickness direction of the core substrate (10), and
a minimum value between the longitudinal diameter and the transverse diameter is greater than or equal to 50 µm.

2. The packaging substrate (100) of claim 1, wherein an aspect ratio of the heat dissipation via (221) observed from the upper surface (11) of the packaging substrate (100) is 0.1 to 10.

3. The packaging substrate (100) of claim 1, wherein, when observed from the upper surface (11) of the packaging substrate (100), the heat dissipation via (221) is disposed to be spaced apart from the cavity portion (21) by 50 µm to 1,000 µm.

4. The packaging substrate (100) of claim 1, comprising two or more heat dissipation vias (221),
wherein the heat dissipation vias (221) are disposed at an interval of 50 µm to 1,000 µm.

5. The packaging substrate (100) of claim 1, wherein when observed from the upper surface (11) of the packaging substrate (100), a ratio of an area of the entire heat dissipation vias (221) to an area of the cavity portion (21) is 1 to 50.

6. The packaging substrate (100) of claim 1, wherein, when the packaging substrate (100) is observed from a cross section in a direction perpendicular to the upper surface (11) of the packaging substrate (100), the heat dissipation via (221) has an hourglass shape.

7. The packaging substrate (100) of claim 1, wherein the mounting region (20) comprises a second heat dissipation portion (30) that is a part formed on an inner side of the cavity portion (21) and disposed adjacent to the cavity portion side surface (211) to transmit heat to the outside.

8. The packaging substrate (100) of claim 7, wherein the mounting region (20) includes a thermally conductive part configured to thermally connect the second heat dissipation portion (30) and the heat dissipation via (221).

9. The packaging substrate (100) of claim 1, wherein the heat dissipation via (221) comprises a thermally conductive layer, and
a difference value in thermal expansion coefficients between the thermally conductive layer and the core substrate (10) is less than or equal to 10 ppm/°C.

10. A semiconductor package comprising:
the packaging substrate (100) according to claim 1; and
a main board electrically connected to the packaging substrate (100).

## Patentansprüche

1. Verpackungssubstrat (100) mit einer Oberseite (11) und einer Unterseite (12), wobei das Verpackungssubstrat (100) umfasst:
einen Befestigungsbereich (20), in dem ein Element untergebracht ist; und
ein Kernsubstrat (10), in dem der Befestigungsbereich (20) angeordnet ist,
wobei das Kernsubstrat (10) ausgewählt ist aus einem Keramiksubstrat, einem Glassubstrat oder einer Kombination davon, und
wobei der Befestigungsbereich (20) umfasst:
einen Hohlraumabschnitt (21), der durch Ausnehmen eines Abschnitts des Kernsubstrats (10) gebildet ist;
eine Hohlraumabschnitt-Seitenfläche (211), die innerhalb des Kernsubstrats (10) in einer Dickenrichtung des Kernsubstrats (10) gebildet ist, um einen Außenumfang des Hohlraumabschnitts (21) zu bilden; und
einen ersten Wärmeableitungsabschnitt (22), der benachbart zu dem Außenumfang des Hohlraumabschnitts (21) angeordnet ist,
wobei der erste Wärmeableitungsabschnitt (22) ein Wärmepfad ist, durch den Wärme des Verpackungssubstrats (100) nach außen übertragbar ist,
wobei der erste Wärmeableitungsabschnitt (22) eine oder mehrere durchgehende Wärmeableitungskontakte (221) umfasst, die jeweils eine Fläche von 5.000 µm² bis 75 mm² aufweisen, wenn sie von der Oberseite (11) des Verpackungssubstrats (100) aus betrachtet werden,
wobei der durchgehende Wärmeableitungskontakt (221) einen Längsdurchmesser und einen Querdurchmesser aufweist,
wobei der durchgehende Wärmeableitungskontakt (221) eine Struktur aufweist, bei der mindestens einer der Längsdurchmesser und der Querdurchmesser in der Dickenrichtung des Kernsubstrats (10) verändert ist, und
ein Minimalwert zwischen dem Längsdurchmesser und dem Querdurchmesser größer oder gleich 50 µm ist.

2. Verpackungssubstrat (100) nach Anspruch 1, wobei ein Seitenverhältnis des durchgehenden Wärmeableitungskontakts (221), von der Oberseite (11) des Verpackungssubstrats (100) betrachtet, 0,1 bis 10 beträgt.

3. Verpackungssubstrat (100) nach Anspruch 1, wobei, wenn von einer Oberseite (11) des Verpackungssubstrats (100) betrachtet der durchgehende Wärmeableitungskontakt (221), in einem Abstand von 50 µm bis 1000 µm von dem Hohlraumabschnitt (21) angeordnet ist.

4. Verpackungssubstrat (100) nach Anspruch 1, das zwei oder mehr durchgehende Wärmeableitungskontakte (221) umfasst,
wobei die durchgehenden Wärmeableitungskontakte (221) in einem Abstand von 50 µm bis 1000 µm angeordnet sind.

5. Verpackungssubstrat (100) nach Anspruch 1, wobei bei Betrachtung von der Oberseite (11) des Verpackungssubstrats (100) das Verhältnis der Fläche aller durchgehenden Wärmeableitungskontakte (221) zu einer Fläche des Hohlraumbereichs (21) 1 bis 50 beträgt.

6. Verpackungssubstrat (100) nach Anspruch 1, wobei der durchgehende Wärmeableitungskontakt (221) bei Betrachtung des Verpackungssubstrats (100) in einem Querschnitt senkrecht zur Oberseite (11) des Verpackungssubstrats (100) eine Sanduhrform aufweist.

7. Verpackungssubstrat (100) nach Anspruch 1, wobei der Befestigungsbereich (20) einen zweiten Wärmeableitungsabschnitt (30) umfasst, der ein Teil ist, der an einer Innenseite des Hohlraumabschnitts (21) ausgebildet und benachbart zur Seitenfläche (211) des Hohlraumabschnitts angeordnet ist, um Wärme nach außen zu übertragen.

8. Verpackungssubstrat (100) nach Anspruch 7, wobei der Befestigungsbereich (20) einen wärmeleitenden Teil umfasst, der so konfiguriert ist, dass er den zweiten Wärmeableitungsabschnitt (30) und den durchgehenden Wärmeableitungskontakt (221) thermisch verbindet.

9. Verpackungssubstrat (100) nach Anspruch 1, wobei der durchgehende Wärmeableitungskontakt (221) eine wärmeleitende Schicht umfasst und
ein Differenzwert der Wärmeausdehnungskoeffizienten zwischen der thermisch leitfähigen Schicht und dem Kernsubstrat (10) kleiner oder gleich 10 ppm/°C ist.

10. Halbleitergehäuse, umfassend:
das Verpackungssubstrat (100) gemäß Anspruch 1; und
eine Hauptplatine, die elektrisch mit dem Verpackungssubstrat (100) verbunden ist.

## Revendications

1. Substrat d'encapsulation (100), présentant une surface supérieure (11) et une surface inférieure (12), ledit substrat d'encapsulation (100) comprenant :
une zone de montage (20) où est logé un élément ; et
un substrat central (10) où la zone de montage (20) est disposée,
où le substrat central (10) est sélectionné entre un substrat céramique, un substrat en verre ou une combinaison de ceux-ci, et
où la zone de montage (20) comprend :
une partie de cavité (21) formée par évidement d'une partie du substrat central (10) ; une surface latérale de la partie de cavité (211) formée à l'intérieur du substrat central (10) dans le sens d'épaisseur du substrat central (10) de manière à former une périphérie extérieure de la partie de cavité (21) ; et
une première partie de dissipation thermique (22) adjacente à la périphérie extérieure de la partie de cavité (21),
où la première partie de dissipation thermique (22) est un trajet thermique par lequel la chaleur du substrat d'encapsulation (100) est transmise vers l'extérieur,
où la première partie de dissipation thermique (22) comprend un ou plusieurs trous de dissipation thermique (221), ayant chacun une surface comprise entre 5.000 µm² et 75 mm² en vue depuis la surface supérieure (11) du substrat d'encapsulation (100),
où le trou de dissipation thermique (221) a un diamètre longitudinal et un diamètre transversal,
où le trou de dissipation thermique (221) présente une structure où le diamètre longitudinal et/ou le diamètre transversal sont modifiés dans le sens de l'épaisseur du substrat central (10), et
une valeur minimale entre le diamètre longitudinal et le diamètre transversal est supérieure ou égale à 50 µm.

2. Substrat d'encapsulation (100) selon la revendication 1, où un rapport d'aspect du trou de dissipation thermique (221) observé depuis la surface supérieure (11) du substrat d'encapsulation (100) est compris entre 0,1 et 10.

3. Substrat d'encapsulation (100) selon la revendication 1, où, en vue depuis la surface supérieure (11) du substrat d'encapsulation (100), le trou de dissipation thermique (221) est disposé de manière à être espacé de 50 µm à 1000 µm de la partie de cavité (21).

4. Substrat d'encapsulation (100) selon la revendication 1, comprenant deux ou plusieurs trous de dissipation thermique (221),
où les trous de dissipation thermique (221) sont disposés à intervalle compris entre 50 µm et 1000 µm.

5. Substrat d'encapsulation (100) selon la revendication 1, où, en vue depuis la surface supérieure (11) du substrat d'encapsulation (100), le rapport entre une zone de l'ensemble des trous de dissipation thermique (221) et une zone de la partie de cavité (21) est compris entre 1 et 50.

6. Substrat d'encapsulation (100) selon la revendication 1, où, lorsque le substrat d'encapsulation (100) est vu depuis une section transversale dans une direction perpendiculaire à la surface supérieure (11) du substrat d'encapsulation (100), le trou de dissipation thermique (221) est en forme de sablier.

7. Substrat d'encapsulation (100) selon la revendication 1, où la zone de montage (20) comprend une deuxième partie de dissipation thermique (30), laquelle est une partie formée sur un côté intérieur de la partie de cavité (21) et adjacente à la surface latérale de la partie de cavité (211) pour transmettre la chaleur vers l'extérieur.

8. Substrat d'encapsulation (100) selon la revendication 7, où la zone de montage (20) comprend une partie thermoconductrice prévue pour connecter thermiquement la deuxième partie de dissipation thermique (30) et le trou de dissipation thermique (221).

9. Substrat d'encapsulation (100) selon la revendication 1, où le trou de dissipation thermique (221) comprend une couche thermoconductrice, et
une valeur de différence des coefficients de dilatation thermique entre la couche thermoconductrice et le substrat central (10) est inférieure ou égale à 10 ppm/°C.

10. Boîtier de semi-conducteur, comprenant :
le substrat d'encapsulation (100) selon la revendication 1 ; et
une carte principale connectée électriquement au substrat d'encapsulation (100).
